Europäisches Patentamt

European Patent Office

Office européen des brevets

(11) Veröffentlichungsnummer: **0 239 785**
**B1**

(12) EUROPÄISCHE PATENTSCHRIFT

(45) Veröffentlichungstag der Patentschrift:
24.10.90

(51) Int. Cl.⁵: **H05K 7/14**

(21) Anmeldenummer: 87102634.0

(22) Anmeldetag: 25.02.87

(54) Zentrierleiste zum Aufstecken auf eine mit Kontaktmessern versehene Rückwandleiterplatte.

(30) Priorität: 27.03.86 DE 3610418

(43) Veröffentlichungstag der Anmeldung:
07.10.87 Patentblatt 87/41

(45) Bekanntmachung des Hinweises auf die Patenterteilung:
24.10.90 Patentblatt 90/43

(84) Benannte Vertragsstaaten:
AT BE CH DE ES FR GB IT LI NL SE

(56) Entgegenhaltungen:
EP-A- 0 123 590
CH-A- 607 542

(73) Patentinhaber: Siemens Aktiengesellschaft,
Wittelsbacherplatz 2, D-8000 München 2(DE)

(72) Erfinder: Pelzl, Leo, Ing. (grad.), Alpenblickstrasse 5,
D-8150 Holzkirchen(DE)
Erfinder: Seidel, Peter, Mittenwalderstrasse 256,
D-8038 Gröbenzell(DE)
Erfinder: Zell, Karl, Dipl.-Ing. (FH),
Moritz-von-Schwind-Weg 80, D-8134 Niederpöcking(DE)

## Beschreibung

Die Erfindung betrifft eine Zentrierleiste zum Aufstecken auf eine mit Kontaktmessern versehene Rückwandleiterplatte, wobei die zur Aufnahme von Steckern dienende Zentrierleiste als einseitig offenes Gehäuse ausgebildet ist und im Boden Durchtrittsöffnungen für die Kontaktmesser aufweist (siehe z.B. CH-A 607 542).

Es ist bekannt, derartige Zentrierleisten an ihren Enden mit Flanschen zu versehen und sie mittels dieser Flansche am Baugruppenrahmen zu befestigen. Dienen die Zentrierleisten z.B. zur Aufnahme von einem oder mehreren Kabelsteckern, so treten beim Stecken der Kabelstecker erhebliche Druckkräfte auf, die zu einer Beschädigung der Zentrierleiste oder einzelner Kontaktmesser führen können. Dieses Problem tritt insbesondere dann auf, wenn Kabelstecker im mittleren Teil der Zentrierleiste gesteckt werden müssen. Beim Stecken von Kabelsteckern, die sich nicht über die gesamte Länge der Zentrierleiste erstrekken, tritt unter der Voraussetzung, daß die Rückwandleiterplatten durchgehend mit Kontaktmessern bestückt sind, und damit auch zwangsläufig die Zentrierleisten, das Problem auf, daß diese Kabelstecker falsch gesteckt werden.

Aufgabe der vorliegenden Erfindung ist es, eine Zentrierleiste der eingangs genannten Art so auszubilden, daß beim Stecken der Kabelstecker eine Beschädigung der Zentrierleiste vermieden wird, wobei aber auch gleichzeitig ein Falschstecken verhindert wird.

Diese Aufgabe wird für eine Zentrierleiste der oben genannten Art erfindungsgemäß dadurch gelöst, daß die Zentrierleiste durch quer angeordnete Zwischenwände in mehrere Segmente aufgeteilt ist, daß jeweils die untere Hälfte der Zwischenwände mit Hohlräumen zur Aufnahme von Kontaktmessern versehen sind, während die beiden Seiten der oberen Hälften der Zwischenwände mechanische Codiereinrichtungen für die aufzunehmenden Stecker aufweisen, wobei jeweils die oberen und unteren Hälften der Zwischenwände durch ein sich über die maximale Breite der Zwischenwände erstreckendes Mittelteil voneinander getrennt sind, und die Tiefe der Hohlräume derart bemessen ist, daß sich die Zentrierleiste mit den Mittelteilen der Zwischenwände auf die Kontaktmesser abstützt.

Die erfindungsgemäße Zentrierleiste erlaubt das Aufstecken auf eine Rückwandleiterplatte, die vollständig mit Kontaktmessern bestückt ist. Dabei stützt sich die erfindungsgemäße Zentrierleiste im Bereich der Zwischenwände auf die dort vorhandenen Kontaktmesser ab. Auf diese Weise werden die beim Stecken von Kabelsteckern erzeugten Druckkräfte auf eine größere Anzahl von Kontaktmessern aufgeteilt, so daß speziell beim Stecken von Kabelsteckern im mittleren Teil der Zentrierleiste ein Durchbiegen derselben verhindert wird. Da die in die unteren Hälften der Zwischenwände eintauchenden Kontaktmesser für einen elektrischen Abgriff ohnehin nicht mehr in Frage kommen, werden die oberen Hälften der Zwischenwände mit mechanischen Codiereinrichtungen für die aufzunehmenden Stecker versehen. Auf diese Weise wird durch den Einbau der erfindungsgemäßen Zwischenwände sowohl die Stabilität der Zentrierleiste beim Stecken von Kabelsteckern erhöht, als auch mögliches Falschstecken der Kabelstecker verhindert.

Eine zweckmäßige Weiterbildung der erfindungsgemäßen Zentrierleiste ist dadurch gekennzeichnet, daß pro aufzunehmenden Kontaktmesser in den Hohlräumen der unteren Hälfte der Zwischenwände eine als Schlitz ausgebildete formschlüssige Halterung vorgesehen ist. Dadurch wird die Stabilität der Zentrierleiste weiter erhöht, da bei der Einwirkung seitlicher Kräfte auf die Zentrierleiste die Torsionskraft der Kontaktmesser zur Halterung mit ausgenutzt wird.

Eine andere zweckmäßige Ausgestaltung der erfindungsgemäßen Zentrierleiste ist dadurch gekennzeichnet, daß die Codiereinrichtungen aus mehreren senkrecht verlaufenden Stegen bestehen. Daraus ergibt sich ein einfacher Aufbau der Codiereinrichtungen.

Eine weitere zweckmäßige Ausgestaltung der Zentrierleiste gemäß der vorliegenden Erfindung ist dadurch gekennzeichnet, daß die Breite der Stege zur Zwischenwand hin abnimmt. Diese Ausbildung der einzelnen Stege hat den Vorteil, daß die Zentrierleiste mit der maximalen Anzahl der möglichen Stege hergestellt werden kann, und daß mittels eines einfachen Werkzeuges je nach Bedarf und Aufbau der verlangten Codierung ein oder mehrere Stege leicht entfernt werden können.

Im folgenden wird die Erfindung anhand eines in der Zeichnung dargestellten Ausführungsbeispiels näher erläutert.

Es zeigen

FIG 1 eine Seitenansicht und
FIG 2 eine Draufsicht der gesamten Zentrierleiste,
FIG 3 eine detaillierte teilweise Draufsicht und
FIG 4 einen entsprechend der Draufsicht in FIG 3 detaillierten teilweisen Schnitt entlang der Längsachse der Zentrierleiste, sowie
FIG 5 einen Querschnitt durch die Zentrierleiste entlang Linie I-II in FIG 4.

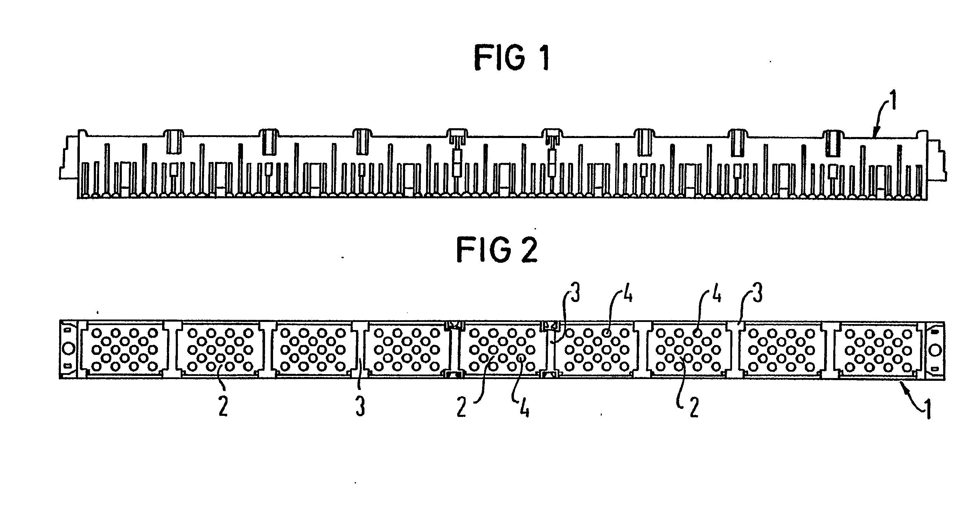

FIG 1 und FIG 2 zeigen den gesamten Aufbau einer erfindungsgemäßen Zentrierleiste 1 in zwei Ansichten. Bei der Beschreibung dieser beiden Figuren sowie bei der Beschreibung der übrigen Figuren, werden nur jeweils die zum Verständnis der vorliegenden Erfindung wesentlichen konstruktiven Merkmale der Zentrierleiste beschrieben. Die Zentrierleiste 1 ist in einzelne Segmente 2 unterteilt, die jeweils durch die Zwischenwände 3 voneinander getrennt sind. Im Boden der Zentrierleiste 1 sind Durchtrittsöffnungen 4 für die Kontaktmesser einer Rückwandleiterplatte vorgesehen. Dabei entspricht die geometrische Anordnung der Durchtrittsöffnungen der geometrischen Anordnung der Kontaktmesser auf der Rückwandleiterplatte.

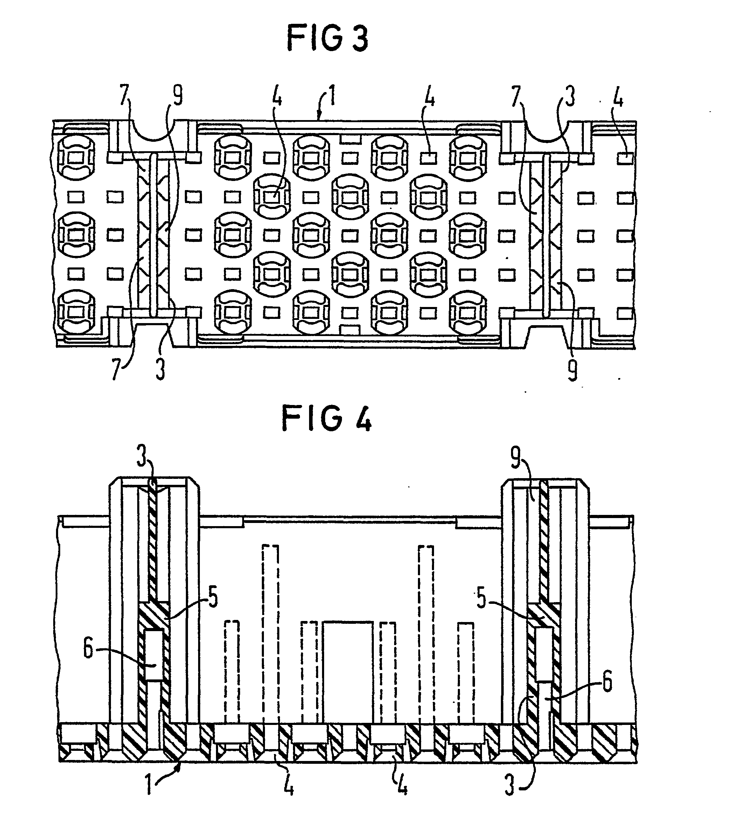

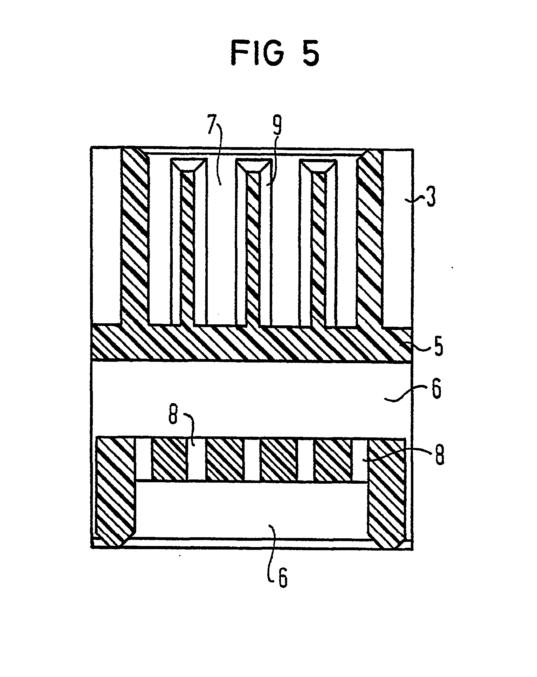

Nachfolgend werden nun die Zwischenwände 3, durch die die erfindungsgemäße Zentrierleiste wesentlich bestimmt ist, näher beschrieben. Der Aufbau der Zwischenwände 3 ergibt sich aus den FIG 3 bis 5.

Jede Zwischenwand besteht aus einer unteren Hälfte zur Aufnahme der Kontaktmesser und einer oberen Hälfte mit den mechanischen Codiereinrichtungen 7. Die beiden Hälften sind durch ein massives Mittelteil 5, welches sich über die maximale Breite der Zwischenwand 3 erstreckt, voneinander getrennt. Die Gesamttiefe der Hohlräume 6 im unteren Teil der Zwischenwand 3 ist so bemessen, daß sich die Zentrierleiste beim Stecken von Kabelsteckern mit der Unterseite des Mittelteils 5 der Zwischenwände 3 auf die Kontaktmesser abstützt. Dadurch werden die beim Stecken erzeugten Druckkräfte auf eine Vielzahl von Kontaktmesser gleichmäßig verteilt, und es wird ein Durchbiegen, bzw. Beschädigen der Zentrierleiste verhindert. Ungefähr in der Mitte der Hohlräume 6 befinden sich pro aufzunehmenden Kontaktmesser als Schlitze 8 ausgebildete formschlüssige Halterungen für die einzelnen Kontaktmesser. Durch diese formschlüssige Halterung wird bei seitlichen Kräften auf die Zentrierleiste die Torsionskraft der Kontaktmesser zur Halterung mit ausgenutzt, was zu einer weiteren Stabilisierung der Zentrierleiste führt. Aus den Figuren ist zu entnehmen, daß die von den Hohlräumen der unteren Hälfte der Zwischenwände 3 aufgenommenen Kontaktmesser im gleichen Raster wie die übrigen Kontaktmesser angeordnet sein können.

Die obere Hälfte der Zwischenwände erhält jeweils auf beiden Seiten als mechanische Codiereinrichtung 7 für die zu steckenden Kabelstecker senkrecht verlaufende Stege 9. Da die in die Hohlräume 6 der Zwischenwände 3 hineinragenden Kontaktmesser ohnehin nicht elektrisch abgegriffen werden können, kann so die obere Hälfte der Zwischenwände 3 entsprechend genutzt werden. Im dargestellten Ausführungsbeispiel sind an jeder Seitenfläche der oberen Hälften der Zwischenwände 3 jeweils drei Stege 9 vorgesehen. Diese Stege 9 sind so ausgebildet, daß die Breite zur Zwischenwand 3 hin abnimmt. Auf diese Weise ist es möglich mit Hilfe eines einfachen Werkzeuges einzelne Stege je nach Bedarf herauszutrennen. Das heißt, daß bei der Herstellung der Zentrierleiste auf die einzelnen Codierungen, wie sie anschließend verwirklicht werden sollen, keine Rücksicht genommen werden braucht. Das eigentliche Codieren erfolgt in der Weise, daß ein entsprechendes Einsatzteil in einen dafür vorgesehenen Schlitz des Kabelsteckers gesteckt wird, welches dort einrastet. An entsprechender Stelle in der Zentrierleiste wird ein Steg 9 herausgetrennt. Das Einsatzteil im Kabelstecker trifft dann beim Steckvorgang auf den herausgetrennten Steg 9. Auf diese Weise wird mit einfachen Mitteln ein Falschstecken von Kabelsteckern verhindert. In diesem Zusammenhang ist noch zu erwähnen, daß sich die einzelnen Kabelstecker über ein oder mehrere Segmente 2 der Zentrierleiste erstrecken können.

**Patentansprüche**

1. Zentrierleiste zum Aufstecken auf eine mit Kontaktmessern versehene Rückwandleiterplatte, wobei die zur Aufnahme von Steckern dienende Zentrierleiste als einseitig offenes Gehäuse ausgebildet ist und im Boden Durchtrittsöffnungen für die Kontaktmesser aufweist, dadurch gekennzeichnet, daß die Zentrierleiste (1) durch quer angeordnete Zwischenwände (3) in mehrere Segmente (2) aufgeteilt ist, daß jeweils die untere Hälfte der Zwischenwände (3) mit Hohlräumen (6) zur Aufnahme von Kontaktmessern versehen sind, während die beiden Seiten der oberen Hälften der Zwischenwände (3) mechanische Codiereinrichtungen (7) für die aufzunehmenden Stecker aufweisen, wobei jeweils die oberen und unteren Hälften der Zwischenwände (3) durch ein sich über die maximale Breite der Zwischenwände (3) erstreckendes massives Mittelteil (5) voneinander getrennt sind, und die Tiefe der Hohlräume (6) derart bemessen ist, daß sich die Zentrierleiste (1) mit den Mittelteilen (5) der Zwischenwände (3) auf die Kontaktmesser abstützt.

2. Zentrierleiste nach Anspruch 1, dadurch gekennzeichnet, daß pro aufzunehmenden Kontaktmesser in den Hohlräumen (6) der unteren Hälfte der Zwischenwände (3) ein als Schlitz (8) ausgebildete formschlüssige Halterung vorgesehen ist.

3. Zentrierleiste nach Anspruch 1, dadurch gekennzeichnet, daß die Codiereinrichtungen (7) aus mehreren senkrecht verlaufenden Stegen (9) bestehen.

4. Zentrierleiste nach Anspruch 3, dadurch gekennzeichnet, daß die Breite der Stege (9) zur Zwischenwand (3) hin abnimmt.

**Claims**

1. Locating strip for plugging onto a rear wall printed circuit board provided with contact blades, the locating strip which serves to receive plugs being constructed as a housing, which is open on one side, and having openings for the contact blades in the floor, characterized in that the locating strip (1) is divided into a plurality of segments (2) by transversely arranged partitions (3), in that in each case the lower half of the partitions (3) is provided with cavities (6) for receiving contact blades, whilst the two sides of the upper halves of the partitions (3) have mechanical coding devices (7) for the plugs to be received, in each case the upper and lower halves of the partitions (3) being separated from one another by a solid centre part (5) extending over the maximum width of the partitions (3), and the depth of the cavities (6) being dimensioned in such a way that the locating strip (1) is supported on the contact blades by means of the centre parts (5) of the intermediate walls (3).

2. Locating strip according to claim 1, characterized in that, in the cavities (6) of the lower half of the intermediate walls (3), one positive-locking bracket constructed as a slot (8) is provided per contact blade to be received.

3. Locating strip according to claim 1, characterized in that the coding devices (7) consist of a plurality of perpendicularly extending webs (9).

4. Locating strip according to claim 3, characterized in that the width of the webs (9) decreases towards the partition (3).

**Revendications**

1. Réglette de centrage destinée à être affichée sur une plaquette à circuits imprimés formant paroi arrière et équipée de couteaux de contact, et dans laquelle la réglette de centrage servant à recevoir des connecteurs est réalisée sous la forme d'un boîtier ouvert unilatéralement et possède des ouvertures de passage, ménagées dans sa base, pour les couteaux de contact, caractérisée par le fait que la réglette de centrage (1) est subdivisée en plusieurs segments (2) par des parois intercalaires transversales (3), que les moitiés inférieures respectives des parois intercalaires (3) comportent des cavités (6) servant à loger les couteaux de contact, tandis que les deux côtés des moitiés supérieures des parois intercalaires (3) possèdent des dispositifs mécaniques de codage (7) pour les connecteurs devant être logés, les moitiés supérieures et inférieures des parois intercalaires (3) étant séparées les unes des autres par un élément médian massif (5), qui s'étend sur toute la largeur maximale des parois intercalaires (3), et la profondeur des cavités (6) étant dimensionnée de telle sorte que la réglette de centrage (1) prend appui, par les parties médianes (5) des parois intercalaires (3), sur les couteaux de contact.

2. Réglette de centrage suivant la revendication 1, caractérisée par le fait que pour chaque couteau de contact devant être logé, il est prévu, dans les cavités (6) des moitiés inférieures des parois intercalaires (3), un système de retenue permettant une liaison par complémentarité de formes et réalisé sous la forme d'une fente (8).

3. Réglette de centrage suivant la revendication 1, caractérisée par le fait que les dispositifs de codage (7) sont constitués par plusieurs barrettes verticales (9).

4. Réglette de centrage suivant la revendication 3, caractérisée par le fait que la largeur des barrettes (9) diminue en direction de la paroi intercalaire (3).

FIG 1

FIG 2

# FIG 3

# FIG 4

# FIG 5